# EUROPÄISCHE PATENTSCHRIFT

(11) **EP 3 362 869 B1**
(45) Veröffentlichungstag und Bekanntmachung des Hinweises auf die Patenterteilung: **26.06.2019**
(21) Anmeldenummer: 16793728.3
(22) Anmeldetag: 07.10.2016
(51) Int. Cl.: G06F 1/18, H05K 5/02, H01R 13/639, H01R 13/62, H05K 5/00, H01R 13/58, H01R 31/00

(54) **ANORDNUNG UMFASSEND EIN ELEKTRISCHES GERÄT UND EIN VERBINDUNGSKABEL**
ARRANGEMENT COMPRISING AN ELECTRICAL DEVICE AND A CONNECTION CABLE
AGENCEMENT COMPORTANT UN APPAREIL ÉLECTRIQUE ET UN CÂBLE DE CONNEXION

(30) Priorität: 12.10.2015 AT 6582015
(43) Veröffentlichungstag der Anmeldung: 22.08.2018
(73) Patentinhaber: Angelbird Technologies GmbH, 6890 Lustenau (AT)
(72) Erfinder: PUSTJENS, Mark Gerardus Petronella, 6850 Dornbirn (AT); RABITSCH, Roman Werner, 6890 Lustenau (AT)
(74) Vertreter: Hofmann, Ralf U.
(86) Internationale Anmeldenummer: PCT/AT2016/000085
(87) Internationale Veröffentlichungsnummer: WO 2017/063005

(56) Entgegenhaltungen:
- WO-A1-03/058765
- GB-A- 2 512 066
- US-A1- 2004 075 977
- US-A1- 2013 235 541

## Beschreibung

Die Erfindung bezieht sich auf eine Anordnung umfassend ein elektrisches Gerät, welches ein Gerätegehäuse und mindestens eine Steckerbuchse mit einer Einstecköffnung aufweist, und ein Verbindungskabel, über das das elektrische Gerät mit einer weiteren elektrischen Einrichtung verbindbar ist und das mit dem Gerät durch einen am Verbindungskabel angebrachten Kabelstecker verbunden ist, welcher ein Steckergehäuse und einen aus dem Steckergehäuse herausragenden Steckfortsatz aufweist, mit dem der Kabelstecker in die Steckerbuchse des elektrischen Geräts eingesteckt ist und der elektrische Kontaktelemente aufweist, die elektrische Gegenkontaktelemente der Steckerbuchse kontaktieren, wobei das Gerätegehäuse mit einem von einer äußeren Oberfläche des Gerätegehäuses ausgehenden Schacht ausgebildet ist, dessen Längserstreckung geradlinig in Richtung einer Längsachse verläuft, und die Verbindung des Verbindungskabels mit dem elektrischen Gerät durch Einstecken des Kabelsteckers in den Schacht erfolgt, wobei der Kabelstecker mit seinem Steckerfortsatz in die Einstecköffnung der Steckerbuchse einsteckbar ist und die Einsteckrichtung des Steckerfortsatzes des Kabelsteckers in die Steckerbuchse parallel zur Längsachse des Schachts liegt und das Steckergehäuse des mit seinem Steckfortsatz in die Steckerbuchse eingesteckten Kabelsteckers zumindest über einen Teil seiner Länge innerhalb des Schachtes des Gerätegehäuses liegt.

Um elektrische Geräte, beispielsweise Computergeräte, mit Peripheriegeräten, wie Speichergeräten, wahlweise zu verbinden, können die zu verbindenden Geräte in herkömmlich bekannter Weise mit Steckerbuchsen ausgestattet sein, in welche an beiden Seiten eines elektrischen Kabels angebrachte Kabelstecker eingesteckt werden. Es sind hierzu unterschiedliche normierte Typen von Steckverbindungen bekannt, im Computerbereich u.a. USB-Steckverbindungen.

Bei vielen Typen von Steckverbindungen, beispielsweise auch USB-Steckverbindungen, ist es möglich, den Kabelstecker durch einen Zug am Kabelstecker oder auch am Kabel aus der Steckerbuchse herauszuziehen, ohne dass dazu zuvor eine Verriegelung gelöst werden muss. Dies hat den Vorteil eines einfachen Schließens und Öffnens der Steckverbindung, allerdings kann es dadurch auch zu einem unbeabsichtigten Öffnen der Steckverbindung kommen, beispielsweise durch eine ungewollte Zugbelastung am Kabel. Falls es sich bei den zu verbindenden Geräten um mobile Geräte handelt, hat die Verbindung der Geräte über ein separates Kabel auch den Nachteil, dass das Mitführen eines solchen Kabels vergessen werden kann oder ein mitgeführtes Kabel verlorengehen kann.

Beispielsweise sind daher Hersteller von externen Speichergeräten, welche insbesondere zum Einsatz im Zusammenhang mit mobilen Computergeräten gedacht sind, teilweise dazu übergegangen, in das Speichergerät ein Kabel fix einzubauen, welches an seinem freien Ende einen Kabelstecker zur Verbindung mit einem Computergerät aufweist. Ein solches fix eingebautes Kabel kann sich somit vom Gerät, in welches es fix eingebaut ist, nicht unabsichtlich lösen und kann nicht vergessen werden, ist aber in anderer Hinsicht nachteilig. So besteht immer die Gefahr eines Kabelbruchs, gerade in dem Bereich, in welchem das in das Gerät fix eingebaute Kabel aus diesem heraustritt. Bei einer der hochintegrierten Bauweise ist aber ein benutzerseitiger Austausch des Kabels im Allgemeinen nicht möglich. Eine Reparatur durch einen Spezialisten ist aber zeitaufwendig und kostenintensiv. Es ist hierbei auch zu bedenken, dass gerade Speichergeräte meist für den Benutzer wertvolle und/oder sensible Daten enthalten. Ein Ersatz des Speichergeräts durch ein anderes wäre mit dem Verlust dieser Daten verbunden.

Um dem Problem des unbeabsichtigten Lösens eines USB-Steckers aus einer USB-Steckerbuchse zu begegnen, sind zusätzliche Verriegelungseinrichtungen bekannt, mittels denen der USB-Stecker in der USB-Buchse gehalten wird. Eine derartige Vorrichtung geht aus der US 7,559,788 B2 hervor.

Neben Peripheriegeräten, die über ein Kabel mit einem Computergerät verbunden werden, sind auch sehr klein ausgebildete Peripheriegeräte bekannt, bei denen ein Steckverbinder, insbesondere USB-Steckverbinder, direkt in das Gerät integriert ist. Das Gerätegehäuse stellt also gleichzeitig ein Steckergehäuse dar, aus welchem der Steckfortsatz des Steckers, insbesondere USB-Steckers, heraussteht. Solche kabellosen USB-Geräte sind beispielsweise in Form von USB-Speichersticks oder USB-Modems mit SIM-Karten weit verbreitet.

Aus der JP 2011-164961 A geht ein kabelloses USB-Gerät mit einer Verriegelungsvorrichtung hervor, um ein unbefugtes Entfernen des USB-Geräts aus dem Computergerät zu verhindern.

Um die auskragende Länge eines kabellosen USB-Geräts, das in ein Computergerät eingesteckt ist, zu verringern, ist es bekannt, einen gegenüber dem Gehäuse des USB-Geräts verschwenkbaren Steckfortsatz vorzusehen. Eine solche Ausbildung geht beispielsweise aus der CN 201345479 Y hervor.

Aus der CN 2010-039596 A geht eine USB-Steckerbuchse mit einem verschwenkbaren Buchsenteil hervor, in welches der Steckfortsatz eines kabellosen USB-Geräts eingesteckt wird. Das verschwenkbare Buchsenteil mit dem eingesteckten USB-Gerät kann so verschwenkt werden, dass die Längsseite des Steckergehäuses des USB-Geräts zur Anlage an das Gerätegehäuse kommt, in welchem die Steckerbuchse montiert ist. Die vorspringende Länge des USB-Geräts wird dadurch reduziert.

Aus der US 2004/0208035 A1 geht ein Speichergerät hervor, welches ein fest eingebautes Kabel mit einem daran angebrachten USB-Kabelstecker aufweist. In einer möglichen Konfiguration steht das Kabel vom Gerätegehäuse ab und der Steckfortsatz des USB-Kabelsteckers kann zur Verbindung des Speichergeräts mit einem Computergerät in eine USB-Steckerbuchse des Computergeräts eingesteckt werden. In einer weiteren Konfiguration kann der USB-Stecker mit dem Kabel eingeklappt werden, sodass das Steckergehäuse des USB-Steckers mit dem Gerätegehäuse verbunden ist und eine Einheit bildet. Zur Verbindung des Geräts mit einem Computer in dieser Konfiguration des Geräts kann der Computer einen Schacht aufweisen, im Bereich von dessen Boden eine USB-Steckerbuchse montiert ist. Das Speichergerät kann hierbei insgesamt in den Schacht eingesteckt werden, wobei der Steckfortsatz des USB-Steckers in die USB-Steckerbuchse eingesteckt wird. Das Speichergerät ist damit als Ganzes im Schacht des Computergehäuses aufgenommen.

Aus der US 2004/0075977 A1 geht ein Notebook-Computer mit einem Aufnahmeschacht für einen USB-Speicherstick hervor. Der USB-Speicherstick wird als Ganzes in den Aufnahmeschacht des Notebook-Computers eingesteckt, wobei der USB-Stecker des Speichersticks in die Steckerbuchse eingesteckt wird. Im eingesteckten Zustand schließt der Speicherstick bündig mit der äußeren Oberfläche des Computergehäuses ab.

Aus der GB 2 512 066 A geht die Aufnahme eines gekrümmten Steckergehäuses eines Kabelsteckers in einem gekrümmten Schacht hervor. Um das Einstecken des Steckergehäuses in die im Schacht angeordnete Steckerbuchse zu ermöglichen, ist die Steckerbuchse verschwenkbar ausgebildet. Das Einstecken des Kabelsteckers in die Steckerbuchse erfolgt bei herausgeklappter Steckerbuchse in eine Richtung schräg zur äußeren Oberfläche des Geräts. Im Folgenden wird die Steckerbuchse mit dem eingesteckten Kabelstecker eingeklappt, wodurch das Steckergehäuse des Kabelsteckers in den Schacht zu liegen gelangt.

Eine Anordnung der eingangs genannten Art geht aus der WO 03/058765 A1 hervor. Ein Gehäuseteil des Gerätegehäuses weist hier einen Kragen auf, der einen Schacht ausbildet, in welchem ein vorderer Abschnitt des eingesteckten Kabelsteckers liegt. Das Einstecken des Kabelsteckers soll dadurch erleichtert werden und die Übertragung von Kräften auf die Lötkontakte der Steckerbuchse, die an einer Platine angelötet ist, soll verringert werden.

Auch bei der aus der US 2013/0235541 A1 bekannten Einrichtung liegt ein vorderer Abschnitt des eingesteckten Kabelsteckers in einem Schacht des Gerätegehäuses. Aufgabe der Erfindung ist es, eine vorteilhafte Verbindung zwischen einem elektrischen Verbindungskabel und einem elektrischen Gerät, insbesondere einem mikroelektronische Bauelemente aufweisenden Gerät, bereitzustellen, durch welche Nachteile der beschriebenen herkömmlichen Verbindungen von Verbindungskabeln mit elektrischen Geräten überwunden werden können. Erfindungsgemäß gelingt dies durch eine Anordnung mit den Merkmalen des Anspruchs 1.

Zur Ausbildung der Verbindung zwischen dem elektrischen Gerät und dem Verbindungskabel ist das Gerätegehäuse des elektrischen Geräts mit einem von einer äußeren Oberfläche des Gerätegehäuses ausgehenden Schacht ausgebildet. Das Gerätegehäuse ist also mit einem zu dieser äußeren Oberfläche des Gerätegehäuses hin offenen Hohlraum ausgebildet, der den Schacht bildet. Wenn der am Verbindungskabel festgelegte Kabelstecker mit seinem Steckfortsatz in die Steckerbuchse des elektrischen Geräts eingesteckt ist, liegt das Steckergehäuse des Kabelsteckers erfindungsgemäß zumindest über mehr als 50% seiner parallel zur Längsachse des Schachts gemessenen Länge, bevorzugt über mehr als zwei Drittel seiner Länge, innerhalb des Schachts des Gerätegehäuses. Die über das Gerätegehäuse vorspringende Länge des Steckergehäuses des Kabelsteckers wird somit zumindest verringert und eine kompaktere Ausbildung wird bereitgestellt. Die Gefahr eines unbeabsichtigten Lösens des Kabelsteckers aus der Steckerbuchse kann schon dadurch verringert werden, dass die freie Angriffsfläche am Steckergehäuse zumindest verringert wird. Im Weiteren ist erfindungsgemäß vorgesehen, dass das Steckergehäuse im Schacht bezüglich eines Bewegungsfreiraums in eine Richtung rechtwinkelig zur Längsachse des Schachts ein Spiel aufweist, welches weniger als 0,5mm, vorzugsweise weniger als 0,3mm, beträgt, oder spielfrei ist und dass das Steckergehäuse im Schacht bezüglich einer Verkippung um eine rechtwinkelig zur Längsachse des Schachts stehende Achse ein Spiel aufweist, welches weniger als 2°, vorzugsweise weniger als 1°, beträgt, oder spielfrei ist.

Wenn ein so geringes Spiel wie zuvor genannt zwischen dem Steckergehäuse und dem Schacht ausgebildet ist, kann erreicht werden, dass es bei einem Zug am Verbindungskabel, der unter einem kleinen Winkel schräg zur Längsachse des Schachts liegt, zu einem Verkanten des Steckergehäuses im Schacht oder zumindest zu einer hohen Reibung des Steckergehäuses gegenüber dem Schacht kommt. Die Gefahr eines versehentlichen Herausziehens des Kabelsteckers aus der Steckerbuchse durch eine auf das Kabel unabsichtlich einwirkende Zugkraft kann dadurch ganz wesentlich verringert werden. Die Wahrscheinlichkeit, dass eine solche unbeabsichtigt auf das Kabel wirkende Zugkraft genau parallel zur Längsachse des Schachts wirkt, ist sehr gering.

Wenn das Steckergehäuse wie zuvor beschrieben gegenüber dem Schacht spielfrei ist, kann das Steckergehäuse auch gegenüber einer parallel zur Längsachse des Schachts wirkenden Zugkraft reibschlüssig im Schacht gehalten sein. Bei einer solchen Ausbildung liegt auch bei einer zentrierten Ausrichtung des Steckergehäuses im Schacht zumindest über einen Teil der parallel zur Längsachse des Schachts gemessenen Länge des Steckergehäuses mindestens über einen Teil oder mehrere Teile des Umfangs des Steckergehäuses ein Kontakt zwischen der äußeren Oberfläche des Steckergehäuses und der den Schacht begrenzenden Wandung vor. Eine formschlüssige Halterung gegenüber einer parallel zur Längsachse des Schachts wirkenden Zugkraft ist hierbei denkbar und möglich. Hierzu kann das Steckergehäuse außen mindestens eine Erhebung aufweisen, die von einem elastisch verformbaren Material des Steckergehäuses gebildet wird und im eingesteckten Zustand des Kabelsteckers in eine Vertiefung in der Wandung des Schachts eingreift. Beispielsweise kann die Erhebung des Steckergehäuses eine in Form einer umfänglich umlaufenden Wulst ausgebildet sein und die Vertiefung in der Wandung des Schachts in Form einer um die Längsachse des Schachts umlaufenden Nut ausgebildet sein.

Vorzugsweise beträgt der Haftreibungskoeffizient zwischen einem zumindest einen Teil der äußeren Oberfläche des Steckergehäuses bildenden Material und einem zumindest einen Teil des die Wandung des Schachts bildenden Materials mehr als 0,7, besonders bevorzugt mehr als 1. Dies ist günstigerweise zumindest für Abschnitte der äußeren Oberfläche des Steckergehäuses und der Wandung des Schachts, welche im eingesteckten Zustand des Kabelsteckers in die Steckerbuchse einander gegenüber liegen, der Fall.

Der Kabelstecker kann in üblicher Weise eine Knickschutztülle für das Verbindungskabel aufweisen. Diese schützt das Verbindungskabel im an den Kabelstecker anschließenden Bereich vor einer Beschädigung durch Knickbelastungen. Im Rahmen dieser Schrift wird die Knickschutztülle als Teil des Steckergehäuses angesehen, und zwar unabhängig davon, ob die Knickschutztülle einstückig mit dem Steckergehäuse ausgebildet ist oder von einem separaten Teil gebildet wird, welches mit einem Hauptteil des Steckergehäuses verbunden ist. In einer vorteilhaften Ausführungsform der Erfindung, bei welcher der Kabelstecker mit einer solchen Knickschutztülle ausgebildet ist, steht im in die Steckerbuchse eingesteckten Zustand des Kabelsteckers lediglich die Knickschutztülle oder ein Teil der Knickschutztülle vom Gerätegehäuse ab, d.h. das Steckergehäuse ist abgesehen von der Knickschutztülle oder einem Teil der Knickschutztülle vollständig im Schacht aufgenommen. Vorzugsweise ist hierbei im Bereich des Übergangs zwischen dem Hauptteil des Steckergehäuses und der Knickschutztülle eine Stufe im Steckergehäuse vorgesehen und diese Stufe liegt bündig mit der äußeren Oberfläche des Gerätegehäuses. Es kann dadurch der optische Eindruck eines fest im Gerät eingebauten Verbindungskabels erweckt werden. Der Kabelstecker kann hierbei weitgehend gegen ein unbeabsichtigtes Lösen aus der Steckerbuchse geschützt sein.

Für den Fall, dass der Kabelstecker ohne Knickschutztülle ausgebildet ist, liegt vorteilhafterweise eine Rückseite des Steckergehäuses bündig zur äußeren Oberfläche des Gerätegehäuses, wenn der Kabelstecker in die Steckerbuchse eingesteckt ist. Auch in diesem Fall kann der optische Eindruck eines fest in das Gerät eingebauten Verbindungskabels erweckt werden und der Kabelstecker weitgehend gegen ein unbeabsichtigtes Lösen aus der Steckerbuchse geschützt sein.

Im Boden des Schachts ist günstigerweise eine Öffnung vorgesehen, deren Querschnittsfläche nur einen Teil der Querschnittsfläche des gesamten Schachts im Bereich von dessen Boden ausmacht. Hierbei ragt der in die Steckerbuchse eingesteckte Steckerfortsatz durch die Öffnung im Boden des Schachts in einen Innenraum des Gerätegehäuses, in welchem zumindest ein Teil der Steckerbuchse liegt, und/oder die Steckerbuchse, die teilweise im Innenraum des Gerätegehäuses liegt, ragt durch die Öffnung im Boden des Schachts aus dem Innenraum des Gerätegehäuses heraus. Es wird damit eine einfache Montage der Steckerbuchse an einer Platine im Innenraum des Gerätegehäuses ermöglicht, wie dies bekannt ist.

Durch die zumindest teilweise Aufnahme des Steckergehäuses im Schacht des Gerätegehäuses kann in einfacher Weise eine wasserdichte oder zumindest wassergeschützte Steckverbindung ermöglicht oder verbessert werden, d.h. ein Eindringen von Wasser in den Innenraum des Gerätegehäuses wird zumindest im in die Steckerbuchse eingesteckten Zustand des Kabelsteckers verhindert oder zumindest erschwert. Hierzu kann es ausreichen, die maximale Größe eines gegebenenfalls vorhandenen Spalts zwischen der äußeren Oberfläche des Steckergehäuses und der Wandung des Schachts ausreichend klein zu machen. Zusätzlich oder stattdessen könnte eine Dichtung vorgesehen sein, die zwischen dem Steckergehäuse und dem Gerätegehäuse liegt und innerhalb des Schachts am Gerätegehäuse angeordnet ist oder an einem Teil des im in die Steckerbuchse eingesteckten Zustand des Kabelsteckers innerhalb des Schachts liegenden Abschnitt des Steckergehäuses angeordnet ist.

Beim elektrischen Gerät der erfindungsgemäßen Anordnung kann es sich um ein Speichergerät, beispielsweise in Form einer SSD handeln. Es kann sich aber auch um ein anderes Peripheriegerät für ein Computergerät oder auch um ein Computergerät handeln, an welches ein Peripheriegerät anschließbar ist. Auch bei anderen elektrischen Geräten, insbesondere solchen mit mikroelektronischen Bauelementen ist die Erfindung einsetzbar.

Weitere Vorteile und Einzelheiten der Erfindung werden im Folgenden anhand der beiliegenden Zeichnung erläutert. In dieser zeigen:
Fig. 1 ein Ausführungsbeispiel der Erfindung, umfassend ein elektrisches Gerät und ein mit dem elektrischen Gerät verbundenes Verbindungskabel, von welchem ein Endabschnitt dargestellt ist, in Schrägsicht;
Fig. 2 eine Schrägsicht des elektrischen Geräts von Fig. 1 allein;
Fig. 3 eine Schrägsicht des Geräts aus einem gegenüber Fig. 2 geänderten Blickwinkel;
Fig. 4 eine Schrägsicht des Gehäusebodens und Gehäusedeckels des Gerätegehäuses im voneinander getrennten Zustand;
Fig. 5 eine Seitenansicht des Geräts mit dem Endabschnitt des mit dem Gerät verbundenen Kabels;
Fig. 6 einen Schnitt entlang der Linie AA von Fig. 5;
Fig. 7 einen vergrößerten Ausschnitt von Fig. 6;
Fig. 8 eine Seitenansicht des Geräts ohne eingestecktes Kabel;
Fig. 9 einen Schnitt entlang der Linie BB von Fig. 8;
Fig. 10 einen vergrößerten Ausschnitt von Fig. 9;
Fig. 11 eine Draufsicht auf das Gerät mit dem damit verbundenen Kabel und einem Abschnitt der mit dem anderen Ende des Kabels verbundenen weiteren elektrischen Einrichtung;
Fig. 12 einen Schnitt durch einen Teil des Geräts im Verbindungsbereich mit dem Kabel entlang der Linie CC von Fig. 11;
Fig. 13 und 14 Teilschnitte entlang den Linien DD und EE von Fig. 11;
Fig. 15 eine Draufsicht auf das Gehäuse ohne verbundenes Kabel;
Fig. 16 einen Schnitt entlang der Linie FF von Fig. 15;
Fig. 17 einen Teilschnitt entlang der Linie GG von Fig. 15;
Fig. 18 bis 20 eine Draufsicht, Seitenansicht und stirnseitige Ansicht der Steckerbuchse;
Fig. 21, 22 und 23 eine Draufsicht, Seitenansicht und stirnseitige Ansicht des am Verbindungskabel angebrachten Kabelsteckers;
Fig. 24 und 25 Schnitte entlang der Linien HH und II von Fig. 21 und 22;
Fig. 26 einen Schnitt eines Kabelsteckers, der in den Schacht eines Gerätegehäuses und eine Steckerbuchse eingesteckt ist, gemäß einem zweiten Ausführungsbeispiel der Erfindung, in einer Schnittdarstellung analog Fig. 7;
Fig. 27 eine entsprechende Schnittdarstellung eines Abschnitts des Geräts ohne den eingesteckten Kabelstecker, analog dem in Fig. 10 dargestellten Schnitt;
Fig. 28 und 29 Schnittdarstellungen eines Abschnitts des Geräts mit dem eingesteckten Kabelstecker und ohne eingesteckten Kabelstecker, in Schnitten analog den Fig. 12 und 16;
Fig. 30 und 31 eine Draufsicht und Seitenansicht des am Verbindungskabel angebrachten Kabelsteckers entsprechend dem zweiten Ausführungsbeispiel.

Die Figuren weisen unterschiedliche Maßstäbe auf. In den Figuren sind die Schnitte durch den Kabelstecker und die Steckerbuchse vereinfacht dargestellt und weitere im Innenraum des Gerätegehäuses enthaltene Komponenten nur schematisch angedeutet.

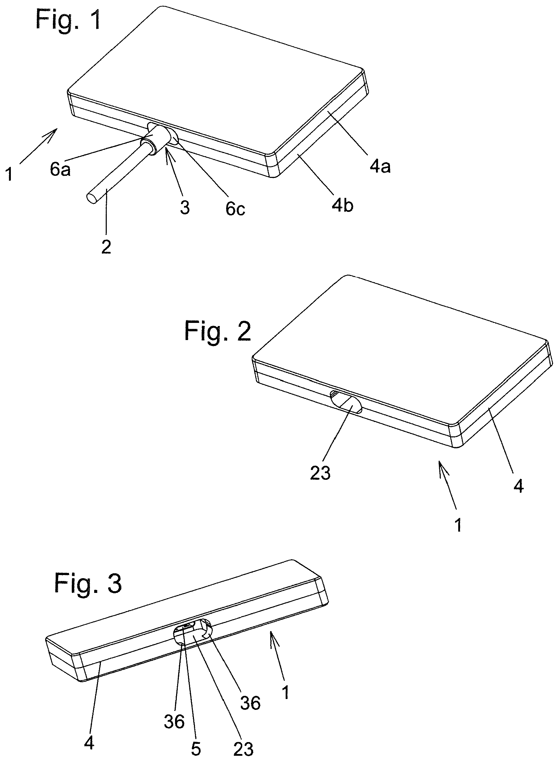

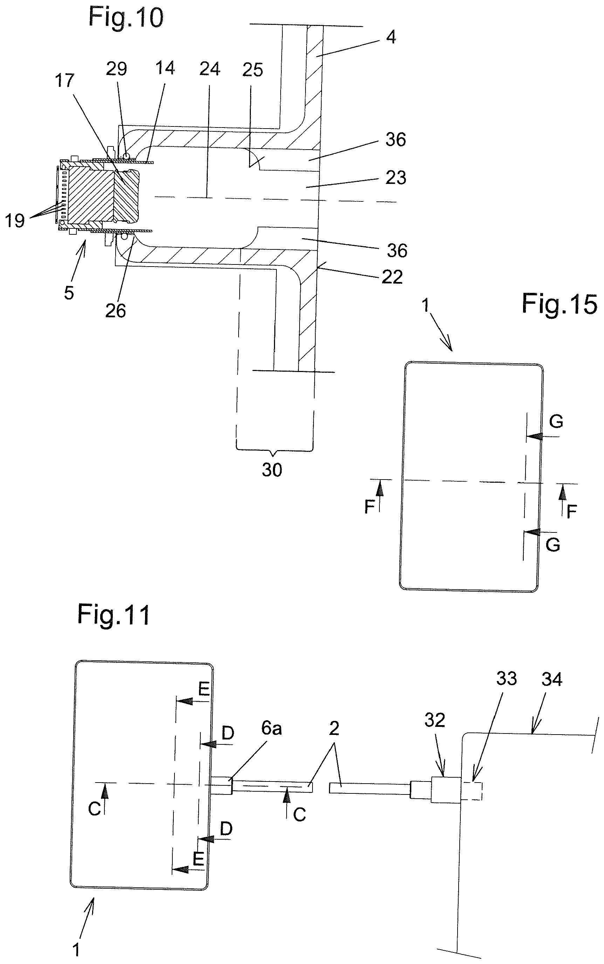

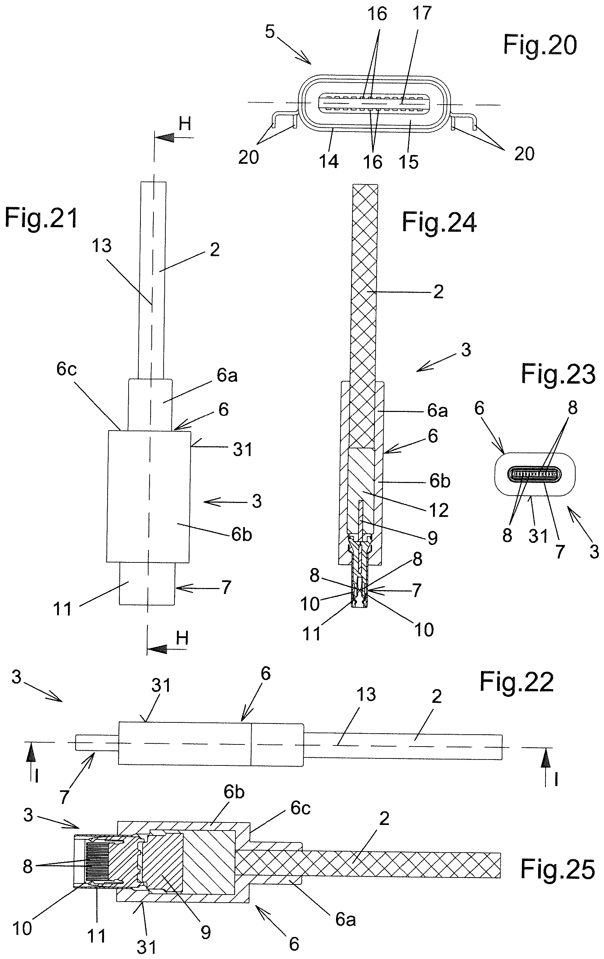

Die in den Figuren 1 bis 25 dargestellte Anordnung umfasst ein elektrisches Gerät 1 und ein elektrisches Verbindungskabel 2 mit einem daran angebrachten Kabelstecker 3. In den Fig. 1, 5-7 und 11-14 ist der mit dem elektrischen Gerät 1 verbundene Zustand des Verbindungskabels gezeigt, wobei abgesehen von Fig. 11 vom Verbindungskabel 2 nur ein an den Kabelstecker 3 anschließender Endabschnitt dargestellt ist. Am anderen Ende des Verbindungskabels ist vorzugsweise ein weiterer Kabelstecker 32 angebracht, um das elektrische Gerät 1 über das Verbindungskabel 2 mit einer weiteren elektrischen Einrichtung 34 zu verbinden, wie in Fig. 11 schematisch dargestellt. Der weitere Kabelstecker 32 kann z.B. gleich ausgebildet sein wie der Kabelstecker 3. Eine Steckerbuchse 33 im Inneren der weiteren elektrischen Einrichtung 34, in die der Kabelstecker 32 eingesteckt ist, ist in Fig. 11 mit gestrichelten Linien angedeutet. Grundsätzlich könnte das Verbindungskabel 2 am anderen Ende auch in die weitere elektrische Einrichtung 34 eingebaut sein, d.h. die Kabellitzen des Verbindungskabels 2 (nicht dargestellt in den Figuren) sind unmittelbar und permanent mit Anschlusselementen der weiteren elektrischen Einrichtung 34 verbunden, beispielsweise an diese angelötet.

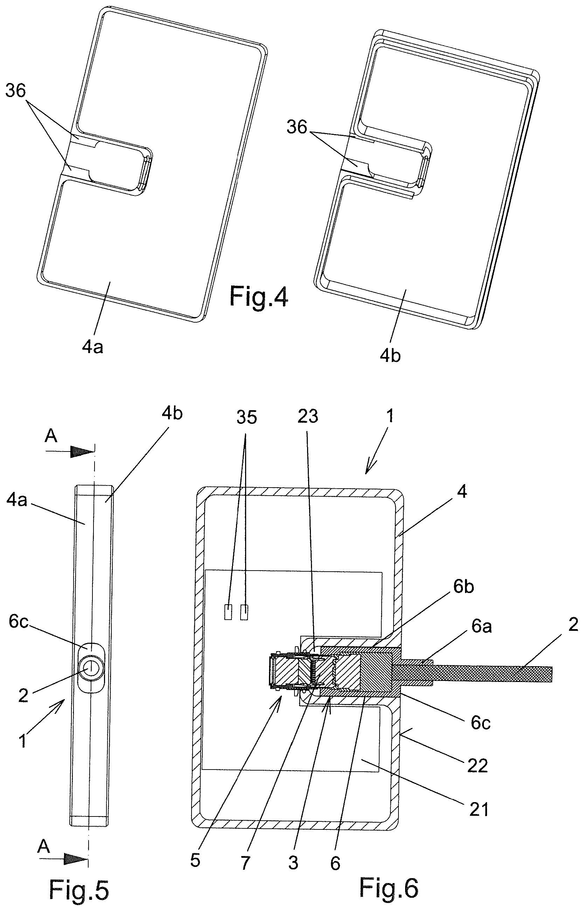

Das elektrische Gerät 1 kann mikroelektronische Bauelemente 35 enthalten, die nur in Fig. 6 zusammen mit einer Platine 21 schematisch angedeutet sind. Beispielsweise kann das elektrische Gerät 1 ein Datenverarbeitungsgerät sein. Insbesondere kann es sich um ein Peripheriegerät eines Computergeräts, z.B. eines mobilen Computergeräts, handeln, beispielsweise um ein Datenspeichergerät. Uber das Verbindungskabel 2 kann dann die Verbindung mit dem Computergerät erfolgen. Durch ein solches Datenspeichergerät, das beispielsweise als SSD ausgebildet ist, kann die Speicherkapazität des Computergeräts erweitert werden.

Andererseits könnte es sich beim elektrischen Gerät 1 beispielsweise auch um ein Computergerät handeln und könnte über das Verbindungskabel 2 eine Verbindung mit einem Peripheriegerät erfolgen.

Elektrische Bauelemente des Geräts 1, welche vorzugsweise mikroelektronische Bauelemente 36 umfassen, sind innerhalb eines Gerätegehäuses 4 angeordnet, also im Innenraum 28 des Gerätegehäuses 4.

Zur Verbindung mit dem am Verbindungskabel 2 angebrachten Kabelstecker 3 weist das elektrische Gerät 1 mindestens eine Steckerbuchse 5 auf. Beim Kabelstecker 3 und bei der Steckerbuchse 5 kann es sich beispielsweise um einen USB-Kabelstecker und eine USB-Steckerbuchse handeln. In einem bevorzugten Ausführungsbeispiel der Erfindung handelt es sich beim Kabelstecker 3 um einen USB-Stecker entsprechend dem Standard 3.1 Typ C und bei der Steckerbuchse 5 um eine diesem Standard entsprechende Steckerbuchse. In den Figuren sind solche Arten von Kabelsteckern 3 und Steckerbuchsen 5 vereinfacht dargestellt.

Der Kabelstecker 3 weist ein Steckergehäuse 6, insbesondere insgesamt oder zumindest teilweise aus Kunststoff, und einen Steckfortsatz 7 auf, der einsteckseitig aus dem Steckergehäuse 6 herausragt. Am Steckfortsatz 7 sind elektrische Kontaktelemente 8 angeordnet. Im in den Figuren dargestellten Ausführungsbeispiel des Kabelsteckers 3 sind zwei Reihen von elektrischen Kontaktelementen 8 vorgesehen, die an einem jeweiligen Kontaktträger 10 angebracht sind und einander gegenüberliegen und einen Zwischenraum zwischen sich aufweisen, in welchen ein Gegenkontaktträger 17 der weiter unten beschriebenen Steckerbuchse 5 einsteckbar ist.

Die elektrischen Kontaktelemente 8 stehen mit den in den Figuren nicht dargestellten Kabellitzen des Verbindungskabels 2 in elektrischer Verbindung. Beispielsweise sind die Kabellitzen an einer Platine 9 angelötet, mit welchen die Kontaktträger 10 verbunden sind. Die Kontaktträger 10 sind von einer Metallhülse 11 umgeben. Die Platine 9 ist von einem Kunststoffteil 12 und einer elektrisch leitenden Abschirmfolie (nicht dargestellt) umgeben. Diese Teile, die innerhalb des Steckergehäuses 6 liegen, sind in den Figuren nur vereinfacht dargestellt und entsprechen dem Stand der Technik.

Beim Steckergehäuse 6 kann es sich insbesondere um ein angespritztes Kunststoffgehäuse handeln, ebenfalls entsprechend dem Stand der Technik. Ein von der Einsteckseite abgelegener Endabschnitt des Steckergehäuses 6, der einstückig mit dem übrigen Steckergehäuse (=Hauptteil 6b des Steckergehäuses) ausgebildet ist, bildet hierbei eine Knickschutztülle 6a. Diese Knickschutztülle 6a umgibt einen Endabschnitt des Verbindungskabels 2. Innerhalb der Knickschutztülle 6a liegt nur das Verbindungskabel 2. Andere Teile des Kabelsteckers liegen nicht im von der Knickschutztülle 6a umgebenen Bereich.

Im in den Fig. 6, 7 und 25 dargestellten Längsmittelschnitt durch den Kabelstecker 3 (also einem parallel zur Längsachse 13 des an den Kabelstecker 3 anschließenden Abschnitts des Kabels 2 verlaufenden Schnitt, der durch die Längsachse 13 führt), liegt eine Stufe 6c zwischen der Knickschutztülle 6a und dem Hauptteil 6b vor. Während der Hauptteil 6b des Steckergehäuses 6 im Ausführungsbeispiel eine eher ovale Ausbildung aufweist, ist die Knickschutztülle 6a im Wesentlichen mit kreisförmiger Außenkontur ausgebildet.

Die Längsachse 13 des Kabels 2 im an den Kabelstecker 3 anschließenden Abschnitt liegt mit der Längsachse des Kabelsteckers 3 auf einer gemeinsamen Geraden.

Die Steckerbuchse 5 weist ein Buchsengehäuse 14 auf, welches von einer, hier teilweise doppelwandig ausgebildeten, Metallhülse gebildet wird. Einsteckseitig weist das Buchsengehäuse 14 eine Einstecköffnung für den Steckfortsatz 7 auf. Die Steckerbuchse besitzt elektrische Gegenkontaktelemente 16 zur Kontaktierung der elektrischen Kontaktelemente 8 des Kabelsteckers 3. Im Ausführungsbeispiel sind die elektrischen Gegenkontaktelemente 16 in zwei Reihen beidseitig eines Gegenkontaktträgers 17 angeordnet. Die dargestellte Steckerbuchse 5 ist entsprechend dem Stand der Technik ausgebildet und die Darstellung ist vereinfacht.

Günstigerweise kann die Steckerbuchse 5 direkt mit einer Platine 21 des elektrischen Geräts 1 verbunden sein, insbesondere an diese angelötet sein. Zur elektrischen Verbindung weist die Steckerbuchse elektrische Verbindungselemente 18, 19 auf, die durch Öffnungen in der Platine 21 durchgesteckt werden (Verbindungselemente 18) und/oder mit oberflächlich angebrachten Kontakten der Platine 21 verbunden werden (Verbindungselemente 19). Zusätzlich können mechanische Verbindungselemente 20 zur Verbindung mit der Platine 21 vorgesehen sein.

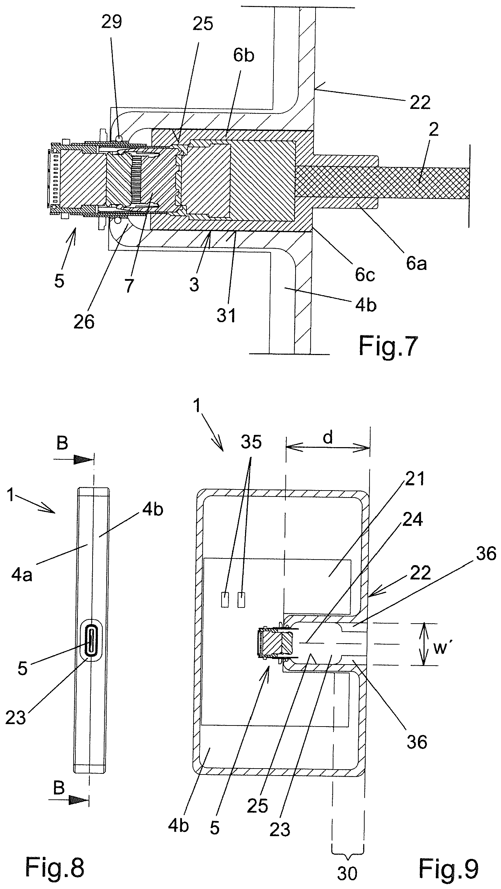

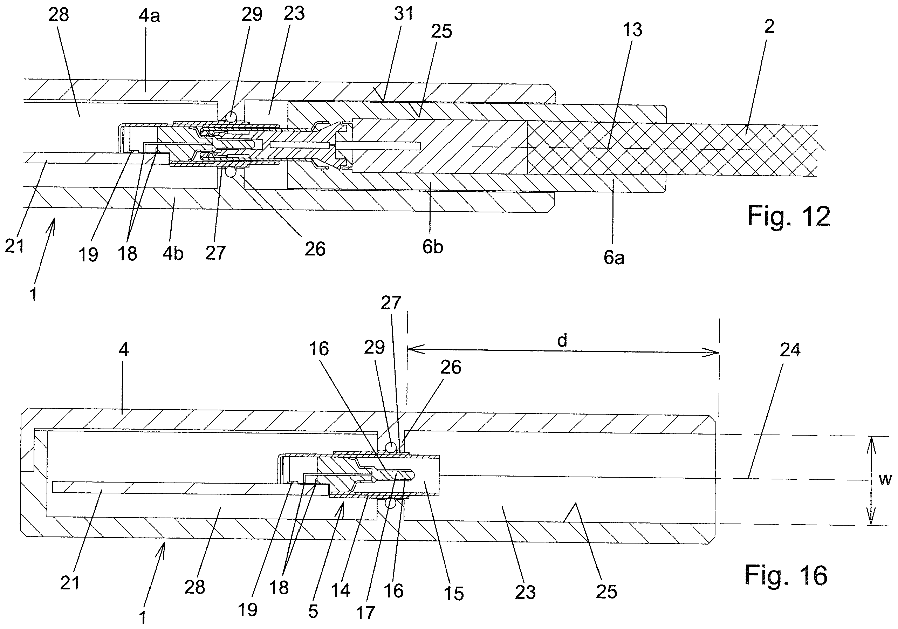

Das Gerätegehäuse 4 weist einen von einer Oberfläche 22 des Gerätegehäuses 4 ausgehenden umfänglich geschlossenen (also umfänglich von einer Wandung umgebenen) Schacht 23 auf. Es ist also ein zur Oberfläche 22 hin offener Kanal oder kanalartiger Hohlraum ausgebildet, dessen Längserstreckung geradlinig in Richtung einer Längsachse 24 verläuft. Die parallel zur Längsachse 24 des Schachts 23 gemessene Tiefe (=Länge) d des Schachts 23 ist hierbei vorzugsweise größer als jede rechtwinkelig zur Längsachse 24 gemessene lichte Weite w, w' des Schachts, vgl. Fig. 9 und 16.

Die Längsachse 24 des Schachts 23 liegt im Ausführungsbeispiel rechtwinkelig zur Oberfläche 22 des Gerätegehäuses 4, von welcher der Schacht 23 ausgeht. Eine hiervon abweichende winkelige Anordnung, beispielsweise im Bereich von 90° +/-45° ist aber denkbar und möglich.

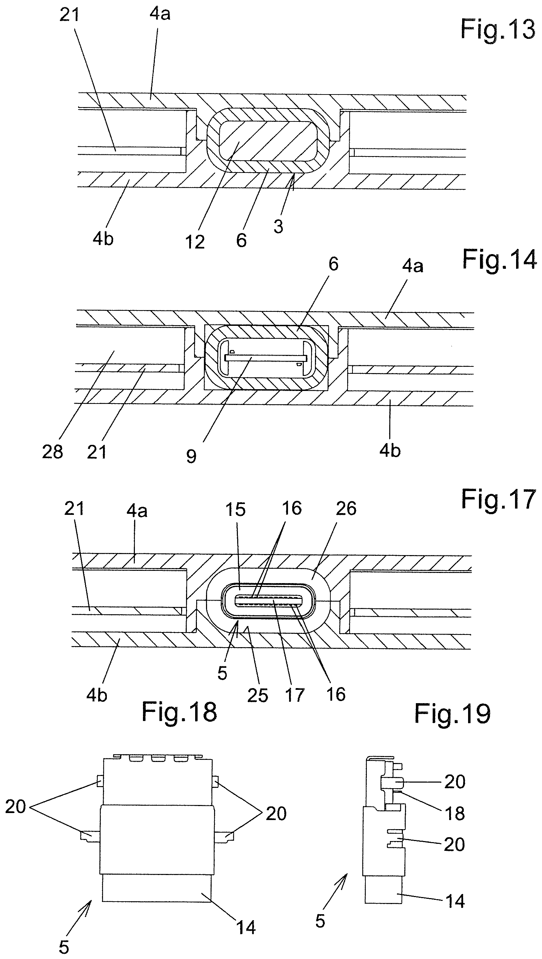

Die den Schacht 23 umfänglich begrenzende(n) Oberfläche(n) werden im Rahmen dieser Schrift in ihrer Gesamtheit als Wandung 25 des Schachts 23 bezeichnet. Im gezeigten Ausführungsbeispiel sind zumindest über einen Abschnitt der Längserstreckung des Schachts im Querschnitt durch den Schacht gesehen, vgl. Fig. 13 und 17, zwei parallele Wände vorhanden, die durch gegenüberliegende kreisbogenförmige Wandabschnitte verbunden sind, angepasst an die äußere Form des Steckergehäuses 6. In anderen Ausführungsbeispielen könnte der Schacht 23 beispielsweise durch eine zylindrische Wand begrenzt sein.

Die den Schacht 23 umfänglich begrenzende Wand bzw. umfänglich begrenzenden Wände liegen zwischen dem Schacht 23 und dem Innenraum 28 des Gerätegehäuses 4. Der Schacht 23 ist also als eine Art "Einstülpung" in das Gerätegehäuse 4 ausgebildet.

Insbesondere liegt die Mündung des Schachts 23 bündig mit einer Seitenwand des Gerätegehäuses 4.

Im Boden 26 des Schachts 23, der den Schacht 23 in seiner Längserstreckung begrenzt, ist eine Öffnung 27 ausgebildet. Die Öffnung 27 befindet sich also zwischen dem Schacht 23 und dem Innenraum 28 des Gerätegehäuses 4. Die Steckerbuchse 5, die im Innenraum 28 des Gerätegehäuses 4 befestigt ist, im Ausführungsbeispiel an der Platine 21, durchsetzt mit ihrem Buchsengehäuse 14 die Öffnung 27 im Boden 26 des Schachts 23.

Zwischen dem Boden 26 und dem Buchsengehäuse 14 ist im Ausführungsbeispiel ein elastischer Dichtungsring 29 angeordnet, der die Steckerbuchse 5 gegenüber dem Boden 26 abdichtet. Wenn die Steckerbuchse 5 auch gegenüber einem Durchtritt von in die Einstecköffnung 15 in die Steckerbuchse 5 eintretendem Wasser abgedichtet ist, ist dadurch der Innenraum 28 des Gerätegehäuses 4 gegen einen Eintritt von Wasser abgedichtet, auch ohne einen in die Steckerbuchse 5 eingesteckten Kabelstecker 3. Der Dichtungsring 29 ist in einer Nut im Bereich der den Boden 26 durchsetzenden Öffnung 27 angeordnet, könnte aber beispielsweise auch an der Außenseite des Buchsengehäuses 14 angeordnet sein, beispielsweise anvulkanisiert oder angespritzt sein.

Zum Verbinden des Verbindungskabels 2 mit dem elektrischen Gerät 1 wird der Kabelstecker 3 mit seinem Steckfortsatz 7 in die Einstecköffnung 15 der Steckerbuchse 5 eingesteckt. Hierzu wird der Kabelstecker 3 in den Schacht 23 eingesteckt. Die Einsteckrichtung des Steckerfortsatzes 7 des Kabelsteckers 3 in die Steckerbuchse 5 liegt parallel zur Längsachse 24 des Schachts 23.

Im eingesteckten Zustand liegt im gezeigten Ausführungsbeispiel der gesamte Hauptteil 6b des Steckergehäuses 6 innerhalb des Schachts 23 und schließt an seiner Rückseite (=Stufe 6c zwischen dem Hauptteil 6b und der Knickschutztülle 6a) bündig mit der Oberfläche 22 des Gerätegehäuses 4 ab, von welcher der Schacht 23 ausgeht. Lediglich die Knickschutztülle 6a des Kabelsteckers 3 ragt somit aus dem Schacht 23 und steht vom Gerätegehäuse 4 ab.

In anderen Ausführungsbeispielen wäre es grundsätzlich auch denkbar und möglich, dass der Hauptteil 6b nicht vollständig im Schacht 23 liegt, also ein hinterer Abschnitt des Hauptteils 6b noch aus dem Schacht herausragt, wobei vorzugsweise weniger als ein Viertel der parallel zur Längsachse 24 des Schachts 23 gemessenen Länge des Hauptteils 6b aus dem Schacht herausragt. Andererseits könnte die Knickschutztülle 6a oder ein Teil der Knickschutztülle 6a ebenfalls innerhalb des Schachts 23 liegen.

Bei einer Ausbildung des Kabelsteckers 3 ohne Knickschutztülle 6a wäre es bevorzugt, dass das hintere Ende des Steckergehäuses 6 bündig mit der Oberfläche 22 abschließt, von der der Schacht 23 ausgeht. Das Steckergehäuse 6 könnte aber auch über einen hinteren Abschnitt aus dem Schacht 23 herausragen, wobei der herausragende Abschnitt vorzugsweise weniger als ein Viertel der gesamten parallel zur Längsachse 24 des Schachts 23 gemessenen Länge des Steckergehäuses 6 betragen würde, oder das eingesteckte Steckergehäuse könnte mit seiner Rückseite innerhalb des Schachts liegen, sodass auch im eingesteckten Zustand eine Vertiefung im Bereich des Schachts verbleibt.

Der Schacht 23 weist einen Führungsabschnitt 30 auf, über welchen die rechtwinkelig zur Längsachse 24 gemessene Breite des Schachts zumindest bezogen auf einen Teil der rechtwinkelig zur Längsachse 24 liegenden Richtungen kleiner ist als in anderen Abschnitten des Schachts 23. Im Ausführungsbeispiel schließt der Führungsabschnitt 30 direkt an die äußere Oberfläche 22 des Gerätegehäuses 4 an, von welcher der Schacht 23 ausgeht. Der Führungsabschnitt könnte aber auch tiefer im Schacht 23 angeordnet sein.

Günstigerweise ist zumindest über den Führungsabschnitt 30 vorgesehen, dass bezogen auf zwei Richtungen, die rechtwinkelig zueinander und rechtwinkelig zur Längsachse des Schachts stehen, der Außendurchmesser des Steckergehäuses weniger als 0,5mm, vorzugsweise weniger als 0,3mm, besonders bevorzugt weniger als 0,2mm, kleiner ist als der Durchmesser des Schachts. Im Ausführungsbeispiel trifft dies auf die gesamte Länge zu, über welche der Kabelstecker in den Schacht eingesteckt ist. Über die Länge des Führungsabschnitts trifft dies im Ausführungsbeispiel auf alle Richtungen rechtwinkelig zur Längserstreckung des Schachts zu.

Das Steckergehäuse 6 des mit seinem Steckfortsatz 7 in die Steckerbuchse 5 eingesteckten Kabelsteckers 3 weist im Führungsabschnitt 30 des Schachts gegenüber dem Schacht ein nur geringes Spiel auf. Günstigerweise beträgt das Spiel im Sinne eines Bewegungsfreiraums bezüglich einer Parallelverschiebung rechtwinkelig zur Längsachse 24 des Schachts 23, weniger als 0,5mm in alle Richtungen rechtwinkelig zur Längsachse 24. Ein Wert von weniger als 0,3mm ist bevorzugt, besonders bevorzugt ein Wert von weniger als 0,2mm. Das Spiel im Sinne eines Bewegungsfreiraums bezüglich einer Verkippung des Steckergehäuses 6 um eine beliebige Achse rechtwinkelig zur Längsachse 24 des Schachts 23 beträgt günstigerweise weniger als 2°, wobei ein Wert von weniger als 1° bevorzugt ist.

In einem anderen Abschnitt des Schachts 23 als dem Führungsabschnitt 30 ist das Spiel zwischen dem Steckergehäuse 6 und der Wandung des Schachts zumindest bezogen auf einen Teil der Richtungen rechtwinkelig zur Längsachse 24 des Schachts 23 größer als im Führungsabschnitt, vgl. Fig. 14.

Der Führungsabschnitt kann durch erhabene Bereiche 36 der Wandung 25 des Schachts ausgebildet werden, vgl. insbesondere Fig. 3, 4 und 10. Im Ausführungsbeispiel finden sich im Querschnitt rechtwinkelig zur Längsachse 24 gesehen solche erhabene Bereiche 36 der Wandung des Schachts 23 in den Eckbereichen des Schachts 23, der ansonsten rechteckförmig ausgebildet ist.

Im Bereich des Führungsabschnitts 30 liegt also günstigerweise eine Spielpassung zwischen dem Steckergehäuse 6 und dem Schacht 23 vor. Nach dem Passungssystem "Einheitsbohrung" könnten insbesondere Spielpassungen entsprechend H8/h9, H7/g6, H7/h6 eingesetzt werden, wobei die Spielpassung H7/g6 bevorzugt ist.

Dadurch, dass eine solche Spielpassung nur über den Führungsabschnitt 30 hergestellt ist und in den übrigen Abschnitten des Schachts ein demgegenüber größeres Spiel gegenüber dem Steckergehäuse 6 vorliegt, kann der Herstellungsaufwand verringert werden. Auch die Gefahr eines Verkantens des Steckergehäuses 6 im Schacht 23 kann verringert werden.

Die parallel zur Längsachse 24 des Schachts 23 gemessene Länge des Führungsabschnitts 30 beträgt vorzugsweise weniger als die Hälfte der Länge d des Schachts 23.

In modifizierten Ausbildungen könnte sich der Führungsabschnitt auch über die gesamte Länge des Schachts 23 erstrecken, über welche die Wandung 25 des Schachts 23 im eingesteckten Zustand des Kabelsteckers 3 dem Steckergehäuse 6 gegenüber liegt, oder der Schacht 23 könnte ohne speziellen Führungsabschnitt 30 ausgebildet werden, d.h. der Schacht 23 weist über seine gesamte Länge die gleichen Querschnittsabmessungen auf, auf welche die obigen Ausführungen zum Führungsabschnitt 30 zutreffen.

Durch das geringe Spiel zwischen dem Steckergehäuse 6 und dem Schacht 23, zumindest im Bereich des Führungsabschnitts 30, kommt es bereits bei einem leicht schräg zur Längsachse 24 des Schachts 23 wirkenden Zug auf das Verbindungskabel 2 zu einem Verkanten des Steckergehäuses 6 im Schacht 23, welches einem Herausziehen des Steckergehäuses 6 aus dem Schacht 23 entgegenwirkt, oder zumindest zu einer starken Erhöhung der Kraft führt, welche für ein Herausziehen des Kabelsteckers 3 aus dem Schacht 23 und aus der Steckerbuchse 5 erforderlich ist.

Dies wird günstigerweise durch einen hohen Haftreibungskoeffizienten (=Haftreibungszahl) unterstützt, der zwischen der äußeren Oberfläche 31 des Hauptteils des Steckergehäuses 6 und der Wandung 25 des Schachts 23 zumindest abschnittsweise vorliegt. Vorzugsweise ist der Haftreibungskoeffizient zwischen dem die äußere Oberfläche 31 des Steckergehäuses 6 bildenden Material und dem Material der Wandung 25 des Schachts 23, welches dieser im Führungsabschnitt 30 aufweist größer als 0,7, vorzugsweise größer als 1.

Beispielsweise kann das Steckergehäuse 6 hierzu aus einem Polyvinylester (PVE) ausgebildet sein. Auch andere Kunststoffe kommen hierzu in Frage. Es könnte auch vorgesehen sein, das Steckergehäuse 6 mit einem entsprechenden Kunststoff mit hohem Reibungskoeffizienten, beispielsweise PVE, zu beschichten. Auch nur über einen Teil des Steckergehäuses (bezogen auf dessen Längserstreckung und/oder Umfang) könnte ein solcher Kunststoff mit hohem Reibungskoeffizienten vorgesehen sein.

Die Wandung des Schachts wird günstigerweise zumindest über den Führungsabschnitt 30 von einer, beispielsweise durch Sandstrahlen, aufgerauten Metalloberfläche gebildet. Eine solche aufgeraute Metalloberfläche könnte auch nur über einen Teil des Umfangs des Schachts 23 und/oder einen Teil der Längserstreckung des Führungsabschnitts 30 vorgesehen sein.

Denkbar und möglich ist es auch, dass das Steckergehäuse 6 des mit seinem Steckfortsatz 7 in die Steckerbuchse 5 eingesteckten Kabelsteckers 3 zumindest bezogen auf einen Bewegungsfreiraum im Sinne einer Parallelverschiebung rechtwinkelig zur Längsachse 24 spielfrei gegenüber dem Schacht 23 ist. Hierzu ist zumindest über einen Abschnitt des Schachts 23 eine Anlage des Steckergehäuses 6 an der Wandung 25 des Schachts 23 ausgebildet. Dies kann insbesondere über einen Teil des Führungsabschnitts 30 vorgesehen sein. Das Steckergehäuse 6 ist dann reibschlüssig oder reibschlüssig und formschlüssig im Schacht 23 gehalten, auch bei einer parallel zur Längsachse 24 auf das Verbindungskabel 2 wirkenden Zugkraft. Der Haftreibungskoeffizient zwischen dem die äußere Oberfläche des Steckergehäuses bildenden Material und dem Material der Wandung 25 des Schachts 23 kann dann zumindest über Teile der aneinander anliegenden Bereiche der äußeren Oberfläche des Steckergehäuses 6 und der Wandung des Schachts 23 mehr als 0,7, vorzugsweise mehr als 1 betragen.

Dass ein geringes Spiel zwischen dem Schacht 23 und dem Steckergehäuse 6, über die gesamte Länge des Schachts 23 oder zumindest einen Teil dieser Länge vorliegt, kann auch so ausgedrückt werden, dass zumindest über einen Abschnitt der Längserstreckung des Schachts 23 bezogen auf den gesamten Umfang um das Steckergehäuse 6 höchstens ein Spalt zwischen dem Steckergehäuse 6 und der Wandung 25 des Schachts 23 vorliegt, dessen Größe weniger als 0,5mm, vorzugsweise weniger als 0,3mm, besonders bevorzugt weniger als 0,2mm beträgt. Günstigerweise beträgt die Länge des Abschnitts des Schachts 23, über welche die maximale Größe des Spalts zwischen dem Steckergehäuse 6 und der Wandung 25 des Schachts 23 in der Weise wie zuvor ausgeführt begrenzt ist, mindestens 3mm, vorzugsweise mindestens 5mm. Bei einer solchen Ausbildung kann, wie bereits erwähnt, vorgesehen sein, dass zumindest an einer Stelle der Längserstreckung des Schachts 23 ein umfänglicher Kontakt des Steckergehäuses 6 mit der Wandung 25 des Schachts 23 vorliegt, beispielsweise indem das Steckergehäuse 6 eine außen umlaufende wulstförmige Erhebung aus einem elastisch verformbaren Material aufweist. Die Wandung 25 des Schachts 23 kann hierbei günstigerweise eine umlaufende nutartige Vertiefung aufweisen, in welche die wulstförmige Erhebung eingreift.

Durch die erfindungsgemäße Ausbildung kann im eingesteckten Zustand des Kabelsteckers 3 ein Schutz gegen ein Eindringen von Wasser bis zu den miteinander in Verbindung stehenden Kontaktelementen 8 und Gegenkontaktelementen 16 bewirkt oder verbessert werden. Ein solcher Schutz kann alleine durch einen geringen Spalt zwischen der äußeren Oberfläche des Steckergehäuses 6 und der Wandung 25 des Schachts 23 ausgebildet werden. Die äußere Oberfläche des Steckergehäuses 6 oder ein über diese vorstehenden, am Steckergehäuse 6 angeordneter Dichtring kann aber auch umfänglich an der Wandung 25 des Schachts 23 anliegen. Stattdessen oder zusätzlich könnte auch an der Wandung 25 des Schachts 23 ein Dichtring vorgesehen sein, der über die Wandung 25 des Schachts 23 vorsteht und umfänglich an der äußeren Oberfläche des Steckergehäuses 4 anliegt.

Das Gerätegehäuse 4 kann wie in den Fig. dargestellt ein Gehäuseoberteil 4a und Gehäuseunterteil 4b umfassen, die miteinander verbunden werden können. Günstigerweise kann hierbei, wie in Fig. 4 dargestellt, ein Teil der Wandung 25 des Schachts 23 vom Gehäuseunterteil 4b und ein weiterer Teil der Wandung 25 des Schachts 23 vom Gehäuseoberteil 4a ausgebildet werden. Insbesondere können das Gehäuseoberteil 4a und das Gehäuseunterteil 4b jeweils halbschalenförmige Bereiche aufweisen, die zusammen den Schacht 23 bilden.

Das Gehäuseunterteil 4b und das Gehäuseoberteil 4a können auch jeweils einen Abschnitt des Bodens 26 des Schachts 23 aufweisen.

In Fig. 4 sind in den Abschnitten des Gehäuseunterteils 4b und Gehäuseoberteils 4a, welche insgesamt die Wandung des Schachts 25 bilden, auch an die äußere Öffnung des Schachts anschließende erhabene Bereiche 36 ersichtlich, um den Führungsabschnitt 30 des Schachts 23 auszubilden.

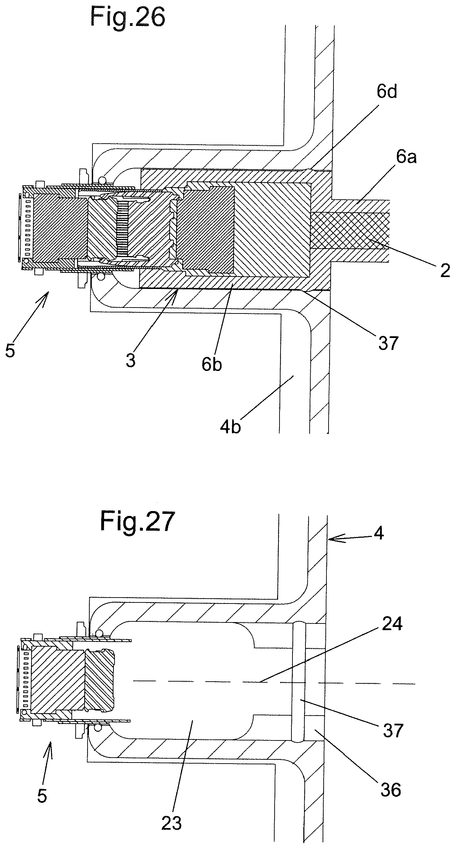

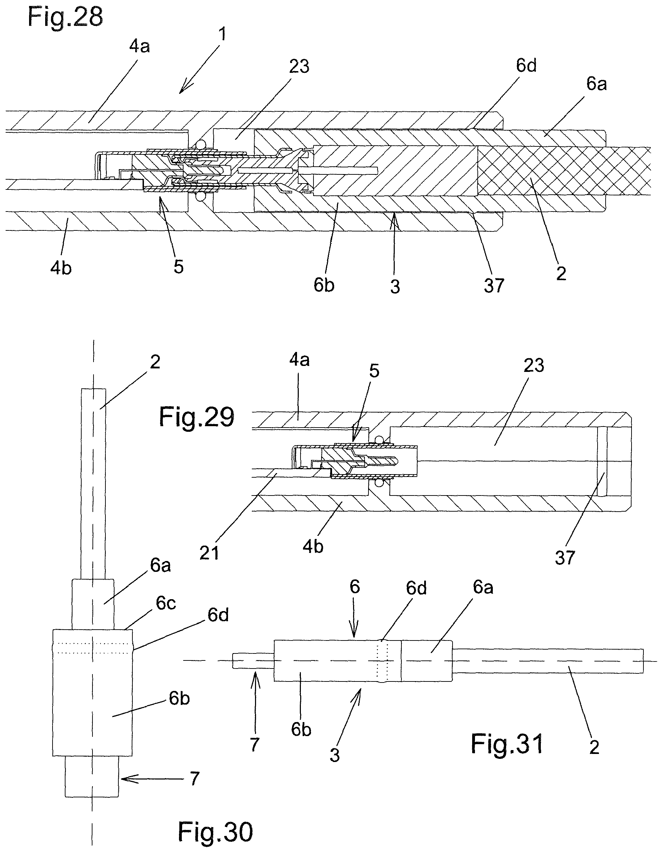

Ein modifiziertes Ausführungsbeispiel der Erfindung wird im Folgenden anhand der Fig. 26 bis 31 erläutert. Abgesehen von den im Folgenden beschriebenen Unterschieden sind die vorausgehenden, auf das erste Ausführungsbeispiel bezogenen Ausführungen auch für dieses zweite Ausführungsbeispiel zutreffend.

In diesem modifizierten Ausführungsbeispiel weist das Steckergehäuse eine umlaufende äußere Erhebung (=Wulst) 6d auf. Diese kann wie dargestellt einstückig mit dem übrigen Steckergehäuse ausgebildet sein.

In der Wandung 25 des Schachts 23 ist eine um die Längsachse 24 des Schachts 23 umlaufende nutartige Vertiefung 37 ausgebildet.

Wenn der Kabelstecker 3 in die Steckerbuchse 5 eingesteckt ist, ragt die Erhebung 6d des Steckergehäuses 6 in die Vertiefung 37. Das die Erhebung 6d bildende elastische Material des Steckergehäuses 6 kann hierbei komprimiert sein. Wenn der Kabelstecker 3 eingesteckt wird und der die Erhebung 6d aufweisende Bereich des Steckergehäuses 6 in den Schacht 23 eingeführt wird, wird das die Erhebung 6d bildende Material zunächst stärker komprimiert und kann sich dann, wenn es in die Vertiefung 37 gelangt, zumindest teilweise entspannen.

Auf diese Weise kommt es im eingesteckten Zustand des Kabelsteckers 3 zu einem Formschluss zwischen dem Kabelstecker 3 und dem Gerätegehäuse 4, der einem Herausziehen des Kabelsteckers 3 aus der Steckerbuchse 5 entgegenwirkt.

Durch eine solche Ausbildung kann auch eine Dichtung gegen ein Eindringen von Wasser bereitgestellt werden.

Andererseits könnte sich die Erhebung 6d, und gegebenenfalls auch die Vertiefung 37, nur über einen Teil des Umfangs erstrecken oder es könnte an einer oder an mehreren Umfangsstellen eine Erhebung, beispielsweise noppenartige Erhebung, vorgesehen sein, die in eine korrespondierende Vertiefung eingreift.

Durch eine solche Ausbildung kann erreicht werden, dass kein spürbares Spiel bezüglich einer Parallelverschiebung des Steckergehäuses rechtwinkelig zur Längsachse 24 des Schachts 23 vorliegt. Wenn Erhebungen 6d und Vertiefungen 37 an unterschiedlichen Stellen bezogen auf die Längserstreckung des Schachts 23 vorgesehen sind, kann im Weiteren erreicht werden, dass kein spürbares Spiel des Steckergehäuses 6 bezüglich eines Verkippens um eine beliebige rechtwinkelig zur Längsachse des Schachts 23 stehende Achse vorliegt.

Die Erfindung ist auch im Zusammenhang mit anderen Typen von Kabelsteckern und Steckerbuchsen als den in den Figuren gezeigten und zuvor beschriebenen einsetzbar. So ist die Erfindung vorteilhaft auch bei Kabelsteckern und Steckerbuchsen nach einem anderen USB-Standard als dem USB 3.1 Typ C einsetzbar. Die Erfindung ist aber auch bei anderen Kabelsteckern und Steckerbuchsen als solchen nach einem USB-Standard einsetzbar.

**Legende zu den Hinweisziffern:**

| | | | |
|---|---|---|---|
| 1 | elektrisches Gerät | 18 | elektrisches Verbindungselement |
| 2 | Verbindungskabel | | |
| 3 | Kabelstecker | 19 | elektrisches |
| 4 | Gerätegehäuse | | Verbindungselement |
| 4a | Gehäuseoberteil | 20 | mechanisches Verbindungselement |
| 4b | Gehäuseunterteil | | |
| 5 | Steckerbuchse | 21 | Platine |
| 6 | Steckergehäuse | 22 | Oberfläche |
| 6a | Knickschutztülle | 23 | Schacht |
| 6b | Hauptteil | 24 | Längsachse |
| 6c | Stufe | 25 | Wandung |
| 6d | Erhebung | 26 | Boden |
| 7 | Steckfortsatz | 27 | Öffnung |
| 8 | elektrisches Kontaktelement | 28 | Innenraum |
| 9 | Platine | 29 | Dichtungsring |
| 10 | Kontaktträger | 30 | Führungsabschnitt |
| 11 | Metallhülse | 31 | Oberfläche |
| 12 | Kunststoffteil | 32 | Kabelstecker |
| 13 | Längsachse | 33 | Steckerbuchse |
| 14 | Buchsengehäuse | 34 | elektrische Einrichtung |
| 15 | Einstecköffnung | 35 | mikroelektronisches Bauelement |
| 16 | elektrisches Gegenkontaktelement | | |
| | | 36 | erhabener Bereich |
| 17 | Gegenkontaktträger | 37 | Vertiefung |

## Patentansprüche

1. Anordnung umfassend ein elektrisches Gerät (1), welches ein Gerätegehäuse (4) und mindestens eine Steckerbuchse (5) mit einer Einstecköffnung (15) aufweist, und ein Verbindungskabel (2), über das das elektrische Gerät (1) mit einer weiteren elektrischen Einrichtung verbindbar ist und das mit dem Gerät durch einen am Verbindungskabel angebrachten Kabelstecker (3) verbunden ist, welcher ein Steckergehäuse (6) und einen aus dem Steckergehäuse (6) herausragenden Steckfortsatz (7) aufweist, mit dem der Kabelstecker (3) in die Steckerbuchse (5) des elektrischen Geräts (1) eingesteckt ist und der elektrische Kontaktelemente (8) aufweist, die elektrische Gegenkontaktelemente (16) der Steckerbuchse (5) kontaktieren, wobei das Gerätegehäuse (4) mit einem von einer äußeren Oberfläche (22) des Gerätegehäuses (4) ausgehenden Schacht (23) ausgebildet ist, dessen Längserstreckung geradlinig in Richtung einer Längsachse (24) verläuft, und die Verbindung des Verbindungskabels (2) mit dem elektrischen Gerät (1) durch Einstecken des Kabelsteckers (3) in den Schacht (23) erfolgt, wobei der Kabelstecker (3) mit seinem Steckerfortsatz (7) in die Einstecköffnung (15) der Steckerbuchse (5) einsteckbar ist und die Einsteckrichtung des Steckerfortsatzes (7) des Kabelsteckers (3) in die Steckerbuchse (5) parallel zur Längsachse (24) des Schachts (23) liegt und das Steckergehäuse (6) des mit seinem Steckfortsatz (7) in die Steckerbuchse (5) eingesteckten Kabelsteckers (3) zumindest über einen Teil seiner Länge innerhalb des Schachtes (23) des Gerätegehäuses (4) liegt, **dadurch gekennzeichnet, dass** das Steckergehäuse (6) über mindestens die Hälfte seiner parallel zur Längsachse (24) des Schachts (23) gemessenen Länge im Schacht (23) liegt und dass das Steckergehäuse (6) im Schacht (23) bezüglich eines Bewegungsfreiraums in eine Richtung rechtwinkelig zur Längsachse (24) des Schachts (23) ein Spiel aufweist, welches weniger als 0,5mm beträgt, oder spielfrei ist und dass das Steckergehäuse (6) im Schacht (23) bezüglich einer Verkippung um eine rechtwinkelig zur Längsachse (24) des Schachts (23) stehende Achse ein Spiel aufweist, welches weniger als 2° beträgt, oder spielfrei ist.

2. Anordnung nach Anspruch 1, **dadurch gekennzeichnet, dass** die Steckerbuchse (5) zumindest teilweise in einem Innenraum (28) des Gerätegehäuses (4) angeordnet ist, und dass der in die Steckerbuchse (5) eingesteckte Steckfortsatz (7) des Kabelsteckers (3) durch eine Öffnung (27) im Gerätegehäuse (4) in den Innenraum (28) des Gerätegehäuses (4) ragt und/oder die Steckerbuchse (5) durch die Öffnung (27) im Gerätegehäuse (4) aus dem Innenraum (28) des Gerätegehäuses (4) herausragt, wobei diese Öffnung (27) im Gerätegehäuse (4) den Boden (26) des Schachts (23) durchsetzt.

3. Anordnung nach Anspruch 1 oder 2, **dadurch gekennzeichnet, dass** das Steckergehäuse (6) im Schacht (23) bezüglich eines Bewegungsfreiraums in eine Richtung rechtwinkelig zur Längsachse (24) des Schachts (23) ein Spiel aufweist, welches weniger als 0,3mm beträgt.

4. Anordnung nach einem der Ansprüche 1 bis 3, **dadurch gekennzeichnet, dass** das Steckergehäuse (6) im Schacht (23) bezüglich einer Verkippung um eine rechtwinkelig zur Längsachse (24) des Schachts (23) stehende Achse ein Spiel aufweist, welches weniger als 1° beträgt.

5. Anordnung nach einem der Ansprüche 1 bis 4, **dadurch gekennzeichnet, dass** der Haftreibungskoeffizient zwischen einem die äußere Oberfläche (31) des Steckergehäuses (6) bildenden Material und einem Material der Wandung (25) des Schachts (23) zumindest über Abschnitte der äußeren Oberfläche (31) des Steckergehäuses (6) und der Wandung (25) des Schachts (23), welche im eingesteckten Zustand des Kabelsteckers (3) in die Steckerbuchse (5) einander gegenüberliegen, größer als 0,7, vorzugsweise größer als 1 ist.

6. Anordnung nach einem der Ansprüche 1 bis 5, **dadurch gekennzeichnet, dass** das Steckergehäuse (6) über mindestens zwei Drittel seiner parallel zur Längsachse (24) des Schachts (23) gemessenen Länge im Schacht (23) liegt.

7. Anordnung nach Anspruch 6, **dadurch gekennzeichnet, dass** das Steckergehäuse (6) eine Knickschutztülle (6a) aufweist, welche das Verbindungskabel (2) über einen Endabschnitt umgibt, wobei die Knickschutztülle (6a) des in die Steckerbuchse (5) eingesteckten Kabelsteckers (3) außerhalb des Schachts (23) liegt und eine Stufe (6c) zwischen der Knickschutztülle (6a) und einem Hauptteil (6b) des Steckergehäuses (6) bündig mit der äußeren Oberfläche (22) des Gerätegehäuses (4) liegt, von welcher der Schacht (23) ausgeht.

8. Anordnung nach Anspruch 6, **dadurch gekennzeichnet, dass** eine Rückseite des Steckergehäuses (6) bündig mit der äußeren Oberfläche (22) des Gerätegehäuses (4) liegt, von welcher der Schacht (23) ausgeht.

9. Anordnung nach einem der Ansprüche 1 bis 8, **dadurch gekennzeichnet, dass** der Schacht (23) einen Führungsabschnitt (30) aufweist, über welchen die rechtwinkelig zur Längsachse (24) des Schachts (23) gemessene lichte Weite des Schachts (23) zumindest für einen Teil der rechtwinkelig zur Längsachse (24) stehenden Richtungen kleiner ist als in einem anderen Abschnitt des Schachts (23).

10. Anordnung nach einem der Ansprüche 1 bis 9, **dadurch gekennzeichnet, dass** das Gerätegehäuse (4) ein Gehäuseunterteil (4b) und ein Gehäuseoberteil (4a) umfasst, welche jeweils einen Teil der Wandung (25) des Schachts (23) ausbilden.

## Claims

1. An arrangement comprising an electrical device (1) which has a device housing (4) and at least one female socket (5) with an insertion opening (15), and a connecting cable (2) by means of which the electrical device (1) can be connected to a further electrical apparatus and which is connected to the device by a cable plug (3) attached to the connecting cable, which plug has a plug housing (6) and an insertion extension (7) projecting out of the plug housing (6) with which the cable plug (3) is inserted into the female socket (5) of the electrical device (1) and which has electrical contact elements (8) which contact electrical counter-contact elements (16) of the female socket (5), wherein the device housing (4) is formed with a shaft (23) which starts from an outer surface (22) of the device housing (4), the longitudinal extent of which shaft runs in rectilinear manner in the direction of a longitudinal axis (24), and the connection of the connecting cable (2) to the electrical device (1) takes place by inserting the cable plug (3) into the shaft (23), wherein the cable plug (3) can be inserted with its plug extension (7) into the insertion opening (15) of the female socket (5) and the direction of insertion of the plug extension (7) of the cable plug (3) into the female socket (5) is parallel to the longitudinal axis (24) of the shaft (23) and the plug housing (6) of the cable plug (3) which is inserted with its insertion extension (7) into the female socket (5) at least over a portion of its length lies within the shaft (23) of the device housing (4), **characterised in that** the plug housing (6) over at least half its length measured parallel to the longitudinal axis (24) of the shaft (23) lies in the shaft (23) and **in that** the plug housing (6) in the shaft (23), with respect to a freedom of movement in a direction at right-angles to the longitudinal axis (24) of the shaft (23), has a play which is less than 0.5 mm, or is without play, and **in that** the plug housing (6) in the shaft (23), with respect to tilting about an axis at right-angles to the longitudinal axis (24) of the shaft (23), has a play which is less than 2°, or is without play.

2. An arrangement according to Claim 1, **characterised in that** the female socket (5) is arranged at least partially in an interior (28) of the device housing (4), and **in that** the insertion extension (7) of the cable plug (3) which is inserted into the female socket (5) projects through an opening (27) in the device housing (4) into the interior (28) of the device housing (4) and/or the female socket (5) projects out of the interior (28) of the device housing (4) through the opening (27) in the device housing (4), this opening (27) in the device housing (4) penetrating through the bottom (26) of the shaft (23).

3. An arrangement according to Claim 1 or 2, **characterised in that** the plug housing (6) in the shaft (23), with respect to a freedom of movement in a direction at right-angles to the longitudinal axis (24) of the shaft (23), has a play which is less than 0.3 mm.

4. An arrangement according to one of Claims 1 to 3, **characterised in that** the plug housing (6) in the shaft (23), with respect to tilting about an axis at right-angles to the longitudinal axis (24) of the shaft (23), has a play which is less than 1°.

5. An arrangement according to one of Claims 1 to 4, **characterised in that** the coefficient of static friction between a material forming the outer surface (31) of the plug housing (6) and a material of the wall (25) of the shaft (23), at least over portions of the outer surface (31) of the plug housing (6) and of the wall (25) of the shaft (23) which are located opposite each other in the state of the cable plug (3) being inserted into the female socket (5), is greater than 0.7, preferably greater than 1.

6. An arrangement according to one of Claims 1 to 5, **characterised in that** the plug housing (6) over at least two thirds of its length measured parallel to the longitudinal axis (24) of the shaft (23) lies in the shaft (23).

7. An arrangement according to Claim 6, **characterised in that** the plug housing (6) has an anti-kink sleeve (6a) which surrounds the connecting cable (2) over an end portion, the anti-kink sleeve (6a) of the cable plug (3) which is inserted into the female socket (5) lying outside the shaft (23) and a step (6c) between the anti-kink sleeve (6a) and a main part (6b) of the plug housing (6) being flush with the outer surface (22) of the device housing (4) from which the shaft (23) starts.

8. An arrangement according to Claim 6, **characterised in that** a rear side of the plug housing (6) is flush with the outer surface (22) of the device housing (4) from which the shaft (23) starts.

9. An arrangement according to one of Claims 1 to 8, **characterised in that** the shaft (23) has a guide portion (30) over which the internal width of the shaft (23) measured at right-angles to the longitudinal axis (24) of the shaft (23), at least for part of the directions which are at right-angles to the longitudinal axis (24), is smaller than in a different portion of the shaft (23).

10. An arrangement according to one of Claims 1 to 9, **characterised in that** the device housing (4) comprises a lower housing part (4b) and an upper housing part (4a) which in each case form part of the wall (25) of the shaft (23).

## Revendications

1. Agencement comprenant un appareil électrique (1) muni d'un boîtier d'appareil (4) et d'au moins une fiche femelle (5) avec une ouverture d'enfichage (15), et un câble de raccordement (2) par le biais duquel l'appareil électrique (1) peut être raccordé à un autre système électrique et qui est raccordé à l'appareil par le biais d'un connecteur de câble (3) fixé au câble de raccordement, lequel connecteur de câble est muni d'un boîtier de connecteur (6) et d'un prolongement de connecteur (7) qui saille du boîtier de connecteur (6) et au moyen duquel le connecteur de câble (3) est enfiché dans la fiche femelle (5) de l'appareil électrique (1), et qui est muni d'éléments de contact (8) électriques qui établissent le contact avec des éléments de contact électriques correspondants (16) de la fiche femelle (5), le boîtier d'appareil (4) étant formé avec un puits (23) qui part d'une surface extérieure (22) du boîtier d'appareil (4) et dont l'extension longitudinale s'étend en ligne droite en direction d'un axe longitudinal (24), et le raccordement du câble de raccordement (2) avec l'appareil électrique (1) étant établi par enfichage du connecteur de câble (3) dans le puits (23) le connecteur de câble (3) pouvant être enfiché avec son prolongement de connecteur (7) dans l'ouverture d'enfichage (15) de la fiche femelle (5) et la direction d'enfichage du prolongement de connecteur (7) du connecteur de câble (3) dans la fiche femelle (5) étant parallèle à l'axe longitudinal (24) du puits (23), et le boîtier de connecteur (6) du connecteur de câble (3) enfiché avec son prolongement de connecteur (7) dans la fiche femelle (5) se trouvant au moins sur une partie de sa longueur à l'intérieur du puits (23) du boîtier d'appareil (4), **caractérisé en ce que** le boîtier de connecteur (6) se trouve dans le puits (23) sur au moins la moitié de sa longueur mesurée parallèlement à l'axe longitudinal (24) du puits (23), et **en ce que** le boîtier de connecteur (6) présente dans le puits (23) un jeu inférieur à 0,5 mm, ou pas de jeu, par rapport à un espace de liberté de mouvement dans une direction perpendiculaire à l'axe longitudinal (24) du puits (23), et **en ce que** le boîtier de connecteur (6) présente dans le puits (23) un jeu inférieur à 2°, ou pas de jeu, par rapport à une inclinaison autour d'un axe perpendiculaire à l'axe longitudinal (24) du puits (23).

2. Agencement selon la revendication 1, **caractérisé en ce que** la fiche femelle (5) est disposée au moins en partie dans un espace intérieur (28) du boîtier d'appareil (4), et **en ce que** le prolongement de connecteur (7) du connecteur de câble (3) enfiché à l'intérieur de la fiche femelle (5) saille à travers une ouverture (27) dans le boîtier d'appareil (4) dans l'espace intérieur (28) du boîtier d'appareil (4) et/ou la fiche femelle (5) saille à travers l'ouverture (27) dans le boîtier d'appareil (4) hors de l'espace intérieur (28) du boîtier d'appareil (4), cette ouverture (27) dans le boîtier (4) traversant le fond (26) du puits (23).

3. Agencement selon la revendication 1 ou 2, **caractérisé en ce que** le boîtier de connecteur (6) dans le puits (23) présente un jeu inférieur à 0,3 mm par rapport à un espace de liberté de mouvement dans une direction perpendiculaire à l'axe longitudinal (24) du puits (23).

4. Agencement selon l'une des revendications 1 à 3, **caractérisé en ce que** le boîtier de connecteur (6) présente dans le puits (23) un jeu inférieur à 1° par rapport à une inclinaison autour d'un axe perpendiculaire à l'axe longitudinal (24) du puits (23).

5. Agencement selon l'une des revendications 1 à 4, **caractérisé en ce que** le coefficient de frottement statique entre un matériau formant la surface extérieure (31) du boîtier de connecteur (6) et un matériau de la paroi (25) du puits (23) est supérieur à 0,7, de préférence supérieur à 1, au moins sur des sections de la surface extérieure (31) du boîtier de connecteur (6) et de la paroi (25) du puits (23) qui se font face à l'état enfiché du connecteur de câble (3) dans la fiche femelle (5).

6. Agencement selon l'une des revendications 1 à 5, **caractérisé en ce que** le boîtier de connecteur (6) se trouve dans le puits (23) sur au moins deux tiers de sa longueur mesurée parallèlement à l'axe longitudinal (24) du puits (23).

7. Agencement selon la revendication 6, **caractérisé en ce que** le boîtier de connecteur (6) est muni d'un manchon anti-pliage (6a) qui entoure le câble de raccordement (2) sur une section d'extrémité, le manchon anti-pliage (6a) du connecteur de câble (3) enfiché dans la fiche femelle (5) se trouvant à l'extérieur du puits (23), et une marche (6c) entre le manchon anti-pliage (6a) et une partie principale (6b) du boîtier de connecteur (6) étant affleurante à la surface extérieure (22) du boîtier d'appareil (4) depuis laquelle part le puits (23).

8. Agencement selon la revendication 6, **caractérisé en ce qu'**une face arrière du boîtier de connecteur (6) est affleurante à la surface extérieure (22) du boîtier d'appareil (4) depuis laquelle part le puits (23).

9. Agencement selon l'une des revendications 1 à 8, **caractérisé en ce que** le puits (23) est muni d'une section de guidage (30) dans laquelle la largeur intérieure du puits (23), mesurée perpendiculairement à l'axe longitudinal (24) du puits (23), est plus petite que dans une autre section du puits (23) au moins pour certaines des directions perpendiculaires à l'axe longitudinal (24).

10. Agencement selon l'une des revendications 1 à 9, **caractérisé en ce que** le boîtier d'appareil (4) comprend une partie inférieure de boîtier (4b) et une partie supérieure de boîtier (4a), qui forment chacune une partie de la paroi (25) du puits (23).
